# EUROPÄISCHE PATENTANMELDUNG

(11) **EP 0 825 769 A2**
(43) Veröffentlichungstag der Anmeldung: **25.02.1998**
(21) Anmeldenummer: 97113687.4
(22) Anmeldetag: 07.08.1997
(51) Int. Cl.: H04N 5/44

(54) **Verfahren und Anordnung zur Programmspeicherung in Rundfunk- oder Fernsehwiedergabegeräten**

(30) Priorität: 23.08.1996 DE 19634142
(71) Anmelder: Bosch-Siemens Hausgeräte GmbH, 81669 München (DE)
(72) Erfinder: Lerch, Dietmar, 85221 Dachau (DE)

(57) **Zusammenfassung**

Die Erfindung betrifft ein Verfahren zur Programmspeicherung in Rundfunk- oder Fernsehwiedergabegeräten, wobei eine Steuerung des Wiedergabegeräts Informationen abspeichert, die Programmquellen (ARD, ZDF, BR, RTL, ...) bezeichnen, wobei ein der Steuerung zugeordnetes Steuerungsprogramm in der Weise ausgestaltet ist, daß in Abhängigkeit eines in das Wiedergabegerät eingegebenen Befehls eine Information in einen Speicher abspeicherbar ist, welche eine von einer Bedienperson bevorzugte Programmquelle bezeichnet, wobei nach einem Einschalten des Wiedergabegeräts diese Information aus dem Speicher abgerufen wird, und das Wiedergabegerät auf einen der Programmquelle zugehörigen Sender eingestellt wird.

Zur Erleichterung der Bedienung des Wiedergabegeräts ist erfindungsgemäß vorgesehen, daß das Steuerungsprogramm in der Weise ausgestaltet ist, daß Zeiten, in denen Rundfunk- oder Fernsehprogramminformationen vorgebbarer Programmquellen wiedergegeben werden, ermittelt werden, und daß Informationen, die diese Zeiten bezeichnen, zugeordnet zu den Informationen, die die jeweilige Programmquellen bezeichnen, abspeicherbar sind, und daß nach einem Einschalten des Wiedergabegeräts aus dem Speicher die Information, die diejenige Programmquelle bezeichnet, abgerufen wird, zu der die längste Wiedergabezeit ermittelt worden ist.

## Beschreibung

Die Erfindung betrifft ein Verfahren und eine Anordnung zur Programmspeicherung in Rundfunk- oder Fernsehwiedergabegeräten nach dem Oberbegriff der Ansprüche 1 bzw. 6.

Es sind Fernsehempfangsgeräte bekannt, die bei einem Einschalten des Geräts dieses auf jeweils auf dieselbe Programmquelle (z.B. Erstes deutsches Fernsehen ARD) einstellen.

Weiterhin sind Fernsehempfangsgerate bekannt, die zusätzlich zu einem Senderspeicher mit einem Speicher ausgestattet sind, der zur Abspeicherung einer Information dient, die ein von der Bedienperson bevorzugtes Programm bezeichnet. Die entsprechenden Prozeduren setzen bestimmte Eingaben des Bedieners in das Gerät bzw. in eine Fernbedienung voraus, wobei in Abhängigkeit der eingegebenen Befehle nach einem Einschalten bzw. Wiedereinschalten des Fernsehempfangsgeräts die dem Befehl entsprechende Information gelesen wird und das Empfangsgerät auf den Sender eingestellt wird, der der von der Bedienperson eingegebenen Information entspricht. Diese Anordnung ist zunachst mit dem Nachteil verbunden, daß Bedienpersonen in der Praxis oft überfordert sind, korrekte Befehlseingaben vorzunehmen. Weiterhin weist diese Anordnung den Nachteil auf, daß weitere Befehle in das Gerät bzw. in eine Fernbedienungsgeber einzugeben sind, wenn die Bedienperson eine andere Einstellung des Geräts nach einem Wiedereinschalten wünscht.

Ausgehend von diesem Stand der Technik liegt der Erfindung die Aufgabe zugrunde, ein Verfahren und eine Anordnung der eingangs genannten Art anzugeben, die in einfacher Weise selbsttätige Einstellungen eines Rundfunk- oder Fernsehwiedergabegeräts ermöglichen.

Die Lösung dieser Aufgabe erfolgt mit einem Verfahren und einer Anordnung, welche in den Ansprüchen definiert sind.

Die Erfindung ist mit einer Mehrzahl von Vorteilen verbunden. Die Bedienperson ist davon entlastet, im Zusammenhang mit der Auswahl einer bevorzugten Programmquelle irgendeine Eingabe in das Rundfunk- oder Fernsehgerät oder in eine Fernbedienung vorzunehmen. Dies gilt auch dann, wenn die Bedienperson im Laufe der Zeit ursprünglich bevorzugte Programme weniger häufig nachfragt und andere Programme bevorzugt. Auch in diesem Fall hat die Bedienperson keinerlei Eingabe in das Gerät bzw. in eine Fernbedienung vorzunehmen, da das geänderte Nachfrageverhalten selbsttätig erfaßt und bei Einschaltvorgängen des Geräts durch Einstellung der entsprechenden Sender bzw. Kanäle umgesetzt wird. Ein weiterer Vorteil des erfindungsgemäßen Verfahrens besteht darin, daß wiedergabegeräteintern relativ wenige Programmschritte durchzuführen sind.

Eine vorteilhafte Ausführungsform der Erfindung ist dadurch gekennzeichnet, daß die Informationen derjenigen Programmquelle, zu der die längste Wiedergabezeit ermittelt worden ist, in einen ersten Speicher eingeschrieben wird. Dies erleichtert den Zugriff der Steuerung des Rundfunk- oder Fernsehgeräts auf die Information, zu welcher die längste Wiedergabezeit ermittelt worden ist, so daß auch die Einstellung auf den zugehörigen Sender mit geringem programmtechnischen Aufwand erfolgt.

Vorzugsweise wird die Information, die diejenige Programmquelle bezeichnet, zu welcher die letzte Wiedergabezeit ermittelt worden ist, in den ersten Speicher zu dem Zeitpunkt eingeschrieben, zu dem auf eine andere Programmquelle umgeschaltet oder das Wiedergabegerät abgeschaltet wird. Damit wird sichergestellt, daß der Inhalt des Speichers stets aktualisiert vorliegt.

Der Inhalt des Speichers, in dem die Information, die diejenige Programmquelle bezeichnet, zu welcher die längste Wiedergabezeit ermittelt worden ist, ist auf einer optischen Anzeigeeinrichtung darstellbar. Damit ist für die Bedienperson ohne weiteres erkennbar, auf welchen Sender das Gerät bei einem Einschalten eingestellt wird.

Eine weitere vorteilhafte Ausführungsform des erfindungsgemäßen Verfahrens ist dadurch gekennzeichnet, daß das Steuerungsprogramm in der Weise ausgestaltet ist, daß durch einen in das Wiedergabegerät eingebbaren Befehl die Informationen löschbar sind, die die Zeiten bezeichnen, in denen Rundfunk- oder Fernsehprogramminformationen unterschiedlicher Programmquellen wiedergegeben werden. Damit kann eine Bedienperson bei einer geänderten Präferenz für ein bestimmtes Programm in einfacher Weise veranlassen, daß sein geändertes Nachfrageverhalten ab dem Zeitpunkt, zu dem er den entsprechenden Befehl eingibt, berücksichtigt wird.

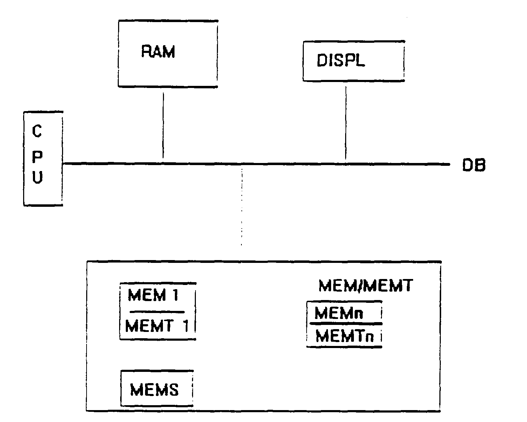

Die Erfindung wird nun anhand der Zeichnung beschrieben. Diese zeigt das Blockschaltbild einer erfindungsgemäßen Anordnung zur Programmspeicherung in Rundfunk- und Fernsehwiedergabegeräten.

Ein Rundfunk- oder Fernsehwiedergabegerät enthält eine Steuerung CPU, die über einen Datenbus DB mit einem Speicher RAM verbunden ist, in dem das Steuerungsprogramm zur Durchführung des erfindungsgemäßen Verfahrens abgespeichert ist. Die Steuerung CPU ist weiterhin über den Datenbus DB mit einem Arbeitsspeicher MEM verbunden, der aus einzelnen Speichern MEM1, MEM2, ..., MEMn und MEMS besteht. Die vorstehend genannten Einzelspeicher MEM1, MEM2, ..., MEMn, MEMS, die als nicht flüchtige Speicher ausgebildet sind, dienen zur Aufnahme von Informationen, die Programmquellen, bspw. Erstes Deutsches Fernsehen ARD. Zweites Deutsches Fernsehen ZDF, etc. bezeichnen. Diese Informationen sind bspw. Informationen, die Fernsehsenderfrequenzen bezeichnen. Ein Einzelspeicher, der Speicher MEMS, der optional vorgesehen ist, dient zur Aufnahme derjenigen Information, die die von der Bedienperson bevorzugte Programmquelle bezeichnet. In der erfindungsgemäßen Anordnung ist dieser Speicher nicht notwendigerweise vorzusehen, wie noch beschrieben wird.

Weiterhin ist ein Arbeitsspeicher MEMT vorgesehen, der aus nicht flüchtigen Einzelspeichern MEMT1, MEMT2, ..., MEMTn besteht. Diese Einzelspeicher dienen zur Aufnahme jeweils einer Zeitinformation, wobei die Zeitinformation die Zeit bezeichnet, in der Rundfunk- oder Fernsehprogramminformationen jeweils einer bestimmten Programmquelle wiedergegeben wurden. Der Einzelspeicher MEM1, der eine Information enthält, die eine bestimmte Programmquelle, z.B. ARD, bezeichnet, und der Einzelspeicher MEMT1, der die Zeit bezeichnet, in der das Programm ARD wiedergegeben worden ist, sind einander logisch zugeordnet: beide Speicher MEM1 und MEMT1 können auch durch einen Speicher gebildet sein.

Die Steuerung CPU ist über dem Datenbus DB auch mit dem Wiedergabeteil des Rundfunk- oder Fernsehwiedergabegeräts verbunden.

Der Steuerung CPU ist ein Steuerungsprogramm zugeordnet, das daß erfindungsgemäße Verfahren definiert. Bei einem erstmaligen Einschalten des Geräts, also bei der Erstinbetriebnahme, kann vorgesehen sein, daß das Gerät auf einen beliebigen Sender eingestellt wird. Die Bedienperson schaltet im Anschluß daran, sofern sie die Wiedergabe eines anderen Programms wünscht, auf eine andere Programmquelle um. Die Zeiten, in denen Rundfunk- oder Fernsehprogramminformationen unterschiedlicher Programmquellen wiedergegeben werden, werden von der Steuerung CPU für jede Programmquelle individuell ermittelt. Die ermittelten Zeiten werden in den jeweiligen Speicher MEMT1 eingeschrieben. Wird bspw. nach der Ersteinstellung des Geräts bei Erstinbetriebnahme die Programmquelle ARD in einem Zeitraum von 10 Sek. wiedergegeben, so wird die entsprechende Zeitinformation (t = 10 Sek.) in den Speicher MEMT1 eingeschrieben. MEMT1 ist dem Speicher MEM1 logisch zugeordnet, der die Programmquelle ARD bezeichnet. Wenn die Bedienperson im dargestellten Beispiel nach 10 Sek. auf die Programmquelle ZDF umschaltet, und diese Programmquelle in einem zweiten Zeitraum t2 = 35 Min. aktiviert, wird die entsprechende Zeitinformation (t2 = 35 Min.) in den Speicher MEMT2 eingeschrieben, der dem MEM2 logisch zugeordnet ist. Der Speicher MEM2 enthält Informationen, die die Programmquelle ZDF bezeichnen.

Das Einschreiben der Information t1 = 10 Sek. in den Speicher MEMT1 erfolgt vorzugsweise zu dem Zeitpunkt, in dem die Umschaltung von der Programmquelle ARD auf die Programmquelle ZDF erfolgt. Die Information t2 = 35 Min., wird zu dem Zeitpunkt in den Speicher MEMT2 eingeschrieben, zu dem entweder das Wiedergabegerät ausgeschaltet oder auf eine weitere Programmquelle, z.B. ARD oder BR (Bayerischer Rundfunk) umgeschaltet wird.

Nach einem Wiedereinschalten des Geräts (Gerät war zuvor ausgeschaltet) wird das Gerät auf den Sender eingestellt, zu welchem die längste Wiedergabezeit ermittelt worden ist. Es kann vorgesehen sein, daß hierzu sämtliche Speicher MEMT1, MEMT2, MEMTn abgefragt werden, um auf diese Weise die längste Zeit zu ermitteln und den zugehörigen Sender (im vorstehenden Beispiel ein Sender, der das Programm des ZDF ausstrahlt) eingestellt wird.

Alternativ kann vorgesehen sein, daß in den Speicher ("erster Speicher") MEMS die Information der Programmquelle eingeschrieben wird, für die die längste Wiedergabezeit ermittelt worden ist. Dieser Einschreibevorgang findet vorzugsweise ebenfalls bei einem Umschalten von einer Programmquelle auf eine andere Programmquelle statt oder beim Ausschalten des Geräts. Nach dem Wiedereinschalten des Geräts greift die CPU unmittelbar auf den Speicher MEMS zu, ruft dort die entsprechende Programmquellen-Information ab und stellt den zugehörigen Sender ein. Die Speicher MEMT1, MEMT2, ..., MEMTn sind im Gegensatz zu der vorstehend dargestellten ersten Alternative beim Wiedereinschalten des Geräts nicht abzufragen.

Das Steuerungsprogramm kann weiterhin in der Weise ausgestaltet sein, daß der Inhalt des Speichers MEMS, in dem die Information, die diejenige Programmquelle bezeichnet, abgespeichert ist, zu welcher die längste Wiedergabezeit ermittelt worden ist, auf einer optischen Anzeigeeinrichtung DISPL dargestellt wird.

Weiterhin kann das Steuerungsprogramm der Steuerung CPU in der Weise ausgestaltet sein, daß durch einen in das Wiedergabegerät bzw. in einen Fernbedienungsgeber, der dem Wiedergabegerät zugeordnet ist, eingegebenen Befehl die Informationen löschbar sind, die die Zeiten bezeichnen, in denen Rundfunk- oder Fernsehprogramm-Informationen unterschiedlicher Programmquellen wiedergegeben werden. Bei einem Wiedereinschalten des Gerats nach einer derartigen Eingabe wird das Gerät entweder auf einen vorgebbaren Sender, z.B. auf einen Sender der Programmquelle ARD, selbsttätig eingestellt. Alternativ hierzu ist vorgesehen, daß eine Einstellung des Senders erst durch einen entsprechenden Einstellbefehl der Bedienperson erfolgt.

## Patentansprüche

1. Verfahren zur Programmspeicherung in Rundfunk- oder Fernsehwiedergabegeräten, wobei eine Steuerung (CPU) des Wiedergabegeräts Informationen abspeichert, die Programmquellen (ARD, ZDF, BR, RTL, ...) bezeichnen, wobei ein der Steuerung (CPU) zugeordnetes Steuerungsprogramm in der Weise ausgestaltet ist, daß in Abhängigkeit eines in das Wiedergabegerät eingegebenen Befehls eine Information in einen Speicher (MEM1, MEM2, ..., MEMn, MEMS) abspeicherbar ist, welche eine von einer Bedienperson bevorzugte Programmquelle bezeichnet, wobei nach einem Einschalten des Wiedergabegeräts diese Information aus dem Speicher abgerufen wird, und das Wiedergabegerät auf einen der Programmquelle zugehörigen Sender eingestellt wird, **dadurch gekennzeichnet,**
daß das Steuerungsprogramm in der Weise ausgestaltet ist, daß Zeiten, in denen Rundfunk- oder Fernsehprogramminformationen vorgebbarer Programmquellen wiedergegeben werden, ermittelt werden,
daß Informationen, die diese Zeiten bezeichnen, zugeordnet zu den Informationen, die die jeweilige Programmquellen bezeichnen, abspeicherbar sind, und
daß nach einem Einschalten des Wiedergabegeräts aus dem Speicher die Information, die diejenige Programmquelle bezeichnet, abgerufen wird, zu der die längste Wiedergabezeit ermittelt worden ist.

2. Verfahren nach Anspruch 1, **dadurch gekennzeichnet,** daß das Steuerungsprogramm in der Weise ausgestaltet ist, daß die Information, die diejenigen Programmquelle bezeichnet, zu der die längste Wiedergabezeit ermittelt worden ist, in einen ersten Speicher (MEMS) eingeschrieben wird.

3. Verfahren nach Anspruch 2, **dadurch gekennzeichnet,** daß das Steuerungsprogramm in der Weise ausgestaltet ist, daß die Information die diejenige Programmquelle bezeichnet, zu der die längste Wiedergabezeit ermittelt worden ist, in den ersten Speicher (MEMS) zu dem Zeitpunkt eingeschrieben wird, zu dem das Wiedergabegerät auf eine andere Programmquelle umgeschaltet oder das Wiedergabegerät abgeschaltet wird.

4. Verfahren nach einem der vorstehenden Ansprüche, **dadurch gekennzeichnet,** daß das Steuerungsprogramm in der Weise ausgestaltet ist, daß der Inhalt des Speichers (MEMS), in dem die Information, die diejenige Programmquelle bezeichnet, abgespeichert ist, zu der die längste Wiedergabezeit ermittelt worden ist, auf einer optischen Anzeigeeinrichtung (DISPL) darstellbar ist.

5. Verfahren nach einem der vorstehenden Ansprüche, **dadurch gekennzeichnet,** daß das Steuerungsprogramm in der Weise ausgestaltet ist, daß durch einen in das Wiedergabegerät eingebbaren Befehl die Informationen löschbar sind, die die Zeiten bezeichnen, in denen Rundfunk- oder Fernsehprogramminformationen vorgebbarer Programmquellen wiedergegeben werden.

6. Anordnung zur Durchführung des Verfahrens nach einem der vorstehenden Ansprüche, **dadurch gekennzeichnet,** daß die Wiedergabegerätesteuerung (CPU) über einen Datenbus (DB) mit einem Speicher (RAM), in dem das Steuerungsprogramm zur Verfahrensdurchführung abspeicherbar ist, und mit dem Speicher (MEM) verbunden ist, in den die Information derjenigen Programmquelle abspeicherbar ist, zu der die längste Wiedergabezeit ermittelt worden ist.

7. Anordnung nach Anspruch 4, **dadurch gekennzeichnet,** daß die die Wiedergabegerätesteuerung (CPU) mit einer optischen Anzeigeeinrichtung (***DISPL***) verbunden ist.
